# EUROPÄISCHE PATENTSCHRIFT

(11) **EP 3 866 300 B1**
(45) Veröffentlichungstag und Bekanntmachung des Hinweises auf die Patenterteilung: **14.10.2026**
(21) Anmeldenummer: 21154496.0
(22) Anmeldetag: 01.02.2021
(51) Int. Cl.: G01R 31/392, H01M 10/48, H02J 7/84

(54) **VERFAHREN ZUR BESTIMMUNG DES ALTERUNGSZUSTANDES MINDESTENS EINER ELEKTRISCHEN ENERGIESPEICHEREINHEIT**
METHOD FOR DETERMINING THE AGEING STATE OF AT LEAST ONE ELECTRICAL ENERGY STORAGE UNIT
PROCÉDÉ DE DÉTERMINATION DE L'ÉTAT DE VIEILLISSEMENT D'AU MOINS UNE UNITÉ D'ACCUMULATION D'ÉNERGIE ÉLECTRIQUE

(30) Priorität: 14.02.2020 DE 102020201836
(43) Veröffentlichungstag der Anmeldung: 18.08.2021
(73) Patentinhaber: Robert Bosch GmbH, 70442 Stuttgart (DE)
(72) Erfinder: Woll, Christoph, 70839 Gerlingen (DE); Doege, Volker, 89561 Dischingen (DE); Simonis, Christian, 71229 Leonberg (DE)

(56) Entgegenhaltungen:
- EP-A1- 2 492 702
- DE-A1- 102015 101 120

## Beschreibung

Die vorliegende Erfindung geht aus von einem Verfahren zur Bestimmung des Alterungszustandes mindestens einer elektrischen Energiespeichereinheit gemäß dem unabhängigen Patentanspruch.

### Stand der Technik

In Folge der zunehmenden Elektrifizierung, insbesondere im Fahrzeug- bzw. Automobilbereich, werden zunehmend mobile elektrische Energiespeichersysteme eingesetzt. Insbesondere bei der vermehrt eingesetzten Lithiumionentechnologie ist eine Einhaltung von vorgegebenen Grenzwerten, beispielsweise Spannungs- und Ladezustandsgrenzwerten, erforderlich, um die Sicherheit und Lebensdauer des elektrischen Energiespeichersystems zu gewährleisten. Weiterhin ist insbesondere für Nutzer dieser elektrischen Energiespeichersysteme eine genaue Kenntnis der Kapazität, d.h. des Speichervermögens, der elektrischen Energiespeichereinheiten des entsprechenden elektrischen Energiespeichersystems relevant. Dabei ist die aktuelle Kapazität ein Kennwert für den Alterungszustand einer elektrischen Energiespeichereinheit. Dazu werden in meist unregelmäßigen Abständen entsprechende Aktualisierungen der Kapazitätswerte der elektrischen Energiespeichereinheiten durch ein Batteriemanagementsystem durchgeführt. Mittels dieser Kapazitätswerte kann einem Nutzer beispielsweise eine verbleibende Restreichweite eines elektrisch angetriebenen Fahrzeugs angezeigt werden. Je häufiger diese Aktualisierungen durchgeführt werden können, desto genauer kann dem Nutzer die Fahrzeugreichweite angezeigt werden. Weiterhin kann durch eine entsprechende Rückkopplung die Genauigkeit eines mathematischen Modells, welches zur Kapazitätsermittlung eingesetzt wird, verbessert werden. Der ermittelte Kapazitätswert kann beispielsweise zu einem Referenzkapazitätswert in Relation gesetzt werden, um einen entsprechenden Alterungskoeffizienten zu ermitteln.

Die Druckschrifte US 2019/0072618 A1 und EP 2492702 A1 beschreiben bekannte Verfahren zur Bestimmung eines Alterungszustandes einer Batterie.

Die Druckschrift CN106526486 A beschreibt ein Verfahren zur Bestimmung eines Alterungszustandes einer Lithiumionenbatterie.

### Offenbarung der Erfindung

### Vorteile der Erfindung

Offenbart wird ein Verfahren zur Bestimmung des Alterungszustandes mindestens einer elektrischen Energiespeichereinheit mit den Merkmalen des unabhängigen Patentanspruchs. Die Alterung der elektrischen Energiespeichereinheit kann sich beispielsweise konkret anhand ihrer Kapazität, d. h. ihres Speichervermögens, beziehungsweise ihres elektrischen Innenwiderstands ausdrücken, indem die Kapazität abnimmt beziehungsweise der elektrische Innenwiderstand zunimmt.

Dabei wird die mindestens eine elektrische Energiespeichereinheit von einem vordefinierten ersten Spannungsniveau oder von einem vordefinierten ersten Ladezustandsniveau auf ein vordefiniertes zweites Spannungsniveau oder auf ein vordefiniertes zweites Ladezustandsniveau entladen. Bevorzugt liegt zwischen den beiden Niveaus ein Spannungsunterschied im Bereich von 0 mV bis 100 mV, insbesondere 20 mV bis 50 mV, um einen Spannungsunterschied zu erhalten, der ausreichend höher ist als die typische Spannungssensorgenauigkeit. Mit dem Spannungsniveau ist hier insbesondere das Klemmenspannungsniveau der elektrischen Energiespeichereinheit gemeint.

Weiterhin wird eine Zeitspanne ermittelt, die das vorstehend beschriebene Entladen benötigt. Dazu wird beispielsweise mit Beginn des Entladevorgangs ein Timer gestartet, der dann bei Erreichen des entsprechenden Niveaus angehalten wird und die entsprechende Entladezeit angibt. Dies kann beispielsweise durch eine elektronische Steuereinheit erfolgen.

Aus der ermittelten Zeitspanne wird der Alterungszustand der mindestens einen elektrischen Energiespeichereinheit bestimmt, wobei dies in Abhängigkeit zumindest der ermittelten Zeitspanne erfolgt. Wird beispielsweise weniger Zeit für den beschriebenen Vorgang benötigt, bedeutet dies, dass die elektrische Energiespeichereinheit gealtert ist und es kann, beispielsweise durch ein Kennfeld, ermittelt werden, wieviel Prozent der ursprünglichen Kapazität die elektrische Energiespeichereinheit noch aufweist.

Das Verfahren ist vorteilhaft, da es einfach umsetzbar ist und auf komplizierte Berechnungen verzichtet. Somit kann es für eine Vielzahl von unterschiedlich gearteten elektrischen Energiespeichereinheiten eingesetzt werden.

Das Verfahren kann beispielsweise computerimplementiert umgesetzt werden.

Weitere vorteilhafte Ausführungsformen der vorliegenden Erfindung sind Gegenstand der Unteransprüche.

Zweckmäßigerweise wird die mindestens eine elektrische Energiespeichereinheit auf das vordefinierte erste Spannungsniveau oder das vordefinierte erste Ladezustandsniveau vor dem Schritt des Entladens geladen oder entladen. Dies ist vorteilhaft, um eine definierte Randbedingung für das Entladen zu haben und gezielt ein Spannungsniveau oder ein Ladezustandsniveau anzusteuern, die für die Bestimmung des Alterungszustandes der mindestens einen elektrischen Energiespeichereinheit besonders günstig sind. Dabei kann beispielsweise das sogenannte CCCV-Ladeverfahren zum Laden eingesetzt werden.

Vor dem Laden wird ein Balancing-Vorgang, auch Spannungsabgleich genannt, durchgeführt, wenn eine Alterungszustandsbestimmung erwünscht wird. Dadurch starten alle elektrischen Energiespeichereinheiten auf gleichem Spannungsniveau den Ladevorgang und erreichen im besten Fall auch die gleiche Zielspannung. Ein mögliches Auseinandertriften der Spannungen während des Ladens wird, wie nachstehend beschrieben, durch ein Balancing nach dem Erreichen der Zielspannung durchgeführt.

Ein Spannungsabgleich wird durchgeführt, sofern die mindestens eine elektrische Energiespeichereinheit mindestens zwei elektrische Energiespeichereinheiten umfasst. Somit ist sichergestellt, dass sich alle elektrischen Energiespeichereinheiten auf einem (nahezu) gleichen Spannungsniveau befinden und somit für alle elektrischen Energiespeichereinheiten die gleichen Randbedingungen herrschen.

Zweckmäßigerweise wird die mindestens eine elektrische Energiespeichereinheit über mindestens einen Widerstand, insbesondere einen ohmschen Widerstand, entladen, wobei der Widerstand zu der mindestens einen elektrischen Energiespeichereinheit parallel geschaltet ist. Der Widerstand kann beispielsweise ein Balancing-Widerstand sein, der normalerweise zum Spannungsabgleich zwischen elektrischen Energiespeichereinheiten eingesetzt wird, sogenanntes Balancing.

Zweckmäßigerweise wird eine Temperatur der mindestens einen elektrischen Energiespeichereinheit ermittelt. Somit erfolgt das Bestimmen des Alterungszustandes der mindestens einen elektrischen Energiespeichereinheit zusätzlich in Abhängigkeit der ermittelten Temperatur. Dies ist vorteilhaft, da somit auch Temperatureinflüsse berücksichtigt werden, die die ermittelte Zeitspanne beim Entladen beeinflussen. Beispielsweise kann in einem Kennfeld für eine bestimmte Zeitspanne und eine bestimmte Temperatur ein bestimmter Alterungszustand hinterlegt sein, welcher somit ermittelt wird.

Zweckmäßigerweise wird der vollgeladene Zustand der elektrischen Energiespeichereinheit durch das vordefinierte erste Spannungsniveau oder das vordefinierte erste Ladezustandsniveau gekennzeichnet. Dabei liegt das vordefinierte erste Spannungsniveau typischerweise bei Lithiumionenbatteriezellen im Bereich von 4,0 Volt bis 4,3 Volt, insbesondere im Bereich von 4,1 Volt bis 4,2 Volt. Dies ist vorteilhaft, da der vollgeladene Zustand beispielsweise während eines Ladevorgangs, beispielsweise durch eine externe Stromzufuhr - ein Ladegerät -, sehr genau erreicht werden kann.

Weiterhin ist Gegenstand der Offenbarung eine Vorrichtung zur Bestimmung des Alterungszustandes mindestens einer elektrischen Energiespeichereinheit, welche mindestens ein Mittel umfasst, das eingerichtet ist, die vorstehend offenbarten Verfahrensschritte auszuführen. Dabei kann das mindestens eine Mittel insbesondere eine elektronische Steuereinheit umfassen. Weiterhin kann das mindestens eine Mittel beispielsweise ein Batteriemanagementsteuergerät und eine entsprechende Leistungselektronik, beispielsweise einen Wechselrichter, sowie Stromsensoren und/oder Spannungssensoren und/oder Temperatursensoren umfassen. Auch eine elektronische Steuereinheit, insbesondere in der Ausprägung als Batteriemanagementsteuergerät, kann solch ein Mittel sein.

Unter einer elektronischen Steuereinheit kann insbesondere ein elektronisches Steuergerät, welches beispielsweise einen Mikrocontroller und/oder einen applikationsspezifischen Hardwarebaustein, z.B. einen ASIC, umfasst, verstanden werden, aber ebenso kann darunter ein Personalcomputer oder eine speicherprogrammierbare Steuerung fallen.

Unter einer elektrischen Energiespeichereinheit kann insbesondere eine elektrochemische Batteriezelle und/oder ein Batteriemodul mit mindestens einer elektrochemischen Batteriezelle und/oder ein Batteriepack mit mindestens einem Batteriemodul verstanden werden. Zum Beispiel kann die elektrische Energiespeichereinheit eine lithiumbasierte Batteriezelle oder ein lithiumbasiertes Batteriemodul oder ein lithiumbasiertes Batteriepack sein. Insbesondere kann die elektrische Energiespeichereinheit eine Lithium-Ionen-Batteriezelle oder ein Lithium-Ionen-Batteriemodul oder ein Lithium-Ionen-Batteriepack sein. Weiterhin kann die Batteriezelle vom Typ Lithium-Polymer-Akkumulator, Nickel-Metallhydrid-Akkumulator, Blei-Säure-Akkumulator, Lithium-Luft-Akkumulator oder Lithium-Schwefel-Akkumulator beziehungsweise ganz allgemein ein Akkumulator beliebiger elektrochemischer Zusammensetzung sein.

Weiterhin ist Gegenstand der Offenbarung ein Computerprogramm, umfassend Befehle, die bewirken, dass die vorgenannte Vorrichtung alle Schritte des offenbarten Verfahrens ausführt. Somit werden die genannten Vorteile erzielt.

Weiterhin ist Gegenstand der Offenbarung ein maschinenlesbares Speichermedium, auf dem das Computerprogramm gespeichert ist. Somit wird neben den genannten Vorteilen eine einfache Verbreitung des Computerprogramms ermöglicht.

Weiterhin ist Gegenstand der Offenbarung ein elektrisches Energiespeichersystem, umfassend mindestens eine elektrische Energiespeichereinheit und die vorstehend beschriebene Vorrichtung. Somit werden die genannten Vorteile realisiert.

### Kurze Beschreibung der Zeichnungen

Vorteilhafte Ausführungsformen der Erfindung sind in den Figuren dargestellt und in der nachfolgenden Beschreibung näher ausgeführt.

### Es zeigen:

- Figur 1: ein Flussdiagramm des offenbarten Verfahrens gemäß einer ersten Ausführungsform;
- Figur 2: ein Flussdiagramm des offenbarten Verfahrens gemäß einer zweiten Ausführungsform;
- Figur 3: ein Diagramm, welches die Alterung und unterschiedlichen Entladezeiten veranschaulicht;
- Figur 4: eine schematische Darstellung des offenbarten elektrischen Energiespeichersystems gemäß einer Ausführungsform.

Ausführungsformen der Erfindung

Gleiche Bezugszeichen bezeichnen in allen Figuren gleiche Vorrichtungskomponenten oder gleiche Verfahrensschritte.

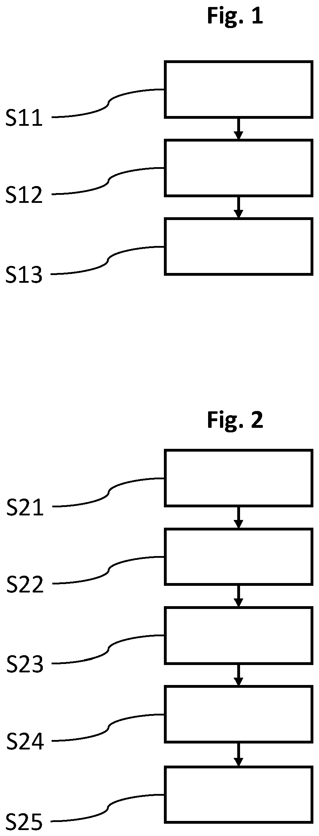

Figur 1 zeigt ein Flussdiagramm des offenbarten Verfahrens zur Bestimmung eines Alterungszustandes mindestens einer elektrischen Energiespeichereinheit gemäß einer ersten Ausführungsform.

In einem ersten Schritt S11 wird die mindestens eine elektrische Energiespeichereinheit von einem vordefinierten ersten Spannungsniveau auf ein vordefiniertes zweites Spannungsniveau entladen. Alternativ kann anstelle des Spannungsniveaus ein Ladezustandsniveau verwendet werden. Dabei ist es vorteilhaft, wenn die elektrische Energiespeichereinheit mit einem vordefinierten Strom entladen wird. Dies kann beispielsweise mittels eines Balancing-Widerstandes umgesetzt werden.

In einem zweiten Schritt S12 wird die Zeitspanne ermittelt, die das Entladen in dem vorhergehenden Schritt benötigt. Somit liegt die Zeitspanne vor, die das Entladen benötigt.

In einem dritten Schritt S13 wird der Alterungszustand der elektrischen Energiespeichereinheit in Abhängigkeit der ermittelten Zeitspanne bestimmt. Dies kann beispielsweise mittels eines Kennfeldes beziehungsweise einer Look-Up-Tabelle erfolgen, in dem für unterschiedliche Entladezeiten unterschiedliche Alterungszustände hinterlegt sind. Diese Zusammenhänge können beispielsweise mittels Laborexperimenten ermittelt werden.

Figur 2 zeigt ein Flussdiagramm des offenbarten Verfahrens zur Bestimmung eines Alterungszustandes mindestens zweier elektrischen Energiespeichereinheiten gemäß einer zweiten Ausführungsform.

In einem ersten Schritt S21 werden die mindestens zwei elektrischen Energiespeichereinheiten auf ein vordefiniertes erstes Ladezustandsniveau geladen beziehungsweise entladen.

In einem zweiten Schritt S22 wird zwischen den mindestens zwei elektrischen Energiespeichereinheiten ein Spannungsabgleich durchgeführt, sogenanntes Balancing. Danach weisen sie das gleiche Spannungsniveau auf. Somit liegen hier vordefinierte Bedingungen für das nachfolgende Entladen mit Zeitspannenermittlung vor, sofern diese vorher nicht bereits geherrscht haben. Dies kann gegebenenfalls die Genauigkeit der Alterungszustandsermittlung erhöhen.

In einem dritten Schritt S23 wird die elektrische Energiespeichereinheit von dem vordefinierten ersten Spannungsniveau auf ein vordefiniertes zweites Spannungsniveau entladen, wie auch vorstehend bei Figur 1 beschrieben.

Dabei wird in einem vierten Schritt S24 die Zeitspanne ermittelt, die das Entladen benötigt.

Mit der ermittelten Zeitspanne wird anschließend in einem fünften Schritt S25 der Alterungszustand der mindestens einen elektrischen Energiespeichereinheit in Abhängigkeit der ermittelten Zeitspanne bestimmt.

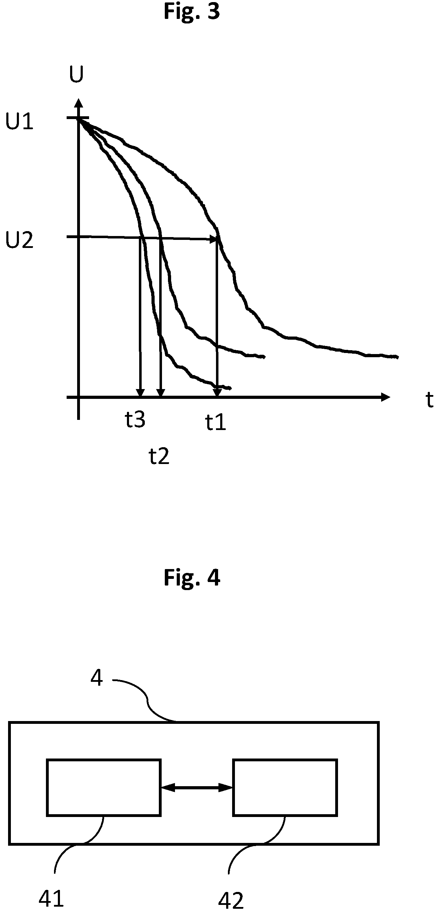

Figur 3 zeigt ein Diagramm, welches die Alterung und unterschiedliche Entladezeiten veranschaulicht. Auf der Ordinatenachse ist die Spannung der elektrischen Energiespeichereinheit abgetragen und auf der Abszissenachse die Zeit. Es sind drei unterschiedliche Entladekurve abgetragen, die von einem ersten vordefinierten Spannungsniveau U1 über ein zweites vordefiniertes Spannungsniveau U2 verlaufen. Dabei weist die elektrische Energiespeichereinheit zu jedem Entladezeitpunkt einen anderen Alterungszustand auf. Dies ist aus den Entladekurven ersichtlich.

Die aus der ersten Entladekurve von dem ersten Spannungsniveau U1 auf das zweite Spannungsniveau U2 benötigte Zeitspanne beträgt t1. Die aus der zweiten Entladekurve von dem ersten Spannungsniveau U1 auf das zweite Spannungsniveau U2 benötigte Zeitspanne beträgt t2 und die aus der dritten Entladekurve von dem ersten Spannungsniveau U1 auf das zweite Spannungsniveau U2 beträgt t3. Dabei gilt t3 < t2 < t1, was bedeutet, dass die elektrische Energiespeichereinheit zum Zeitpunkt des dritten Entladens, wobei sich die dritte Entladekurve ergab, eine stärkere Alterung aufweist als zu den vorhergehenden Zeitpunkten. Eine stärkere Alterung bedeutet hier beispielsweise konkret eine geringere Kapazität beziehungsweise einen größeren elektrischen Innenwiderstand.

Figur 4 zeigt eine schematische Darstellung des offenbarten elektrischen Energiespeichersystems 4 gemäß einer Ausführungsform. Das elektrische Energiespeichersystem 4 umfasst eine elektrische Energiespeichereinheit 41 und eine erfindungsgemäße Vorrichtung 42 zur Bestimmung des Alterungszustandes der elektrischen Energiespeichereinheit 41. Dabei umfasst die Vorrichtung 42 ein Mittel, das eingerichtet ist, das offenbarte Verfahren auszuführen. Das Mittel ist nicht dargestellt.

## Patentansprüche

1. Verfahren zur Bestimmung eines Alterungszustandes mindestens einer elektrischen Energiespeichereinheit (41), umfassend die Schritte:
a) Durchführen eines Spannungsabgleichs zwischen mindestens zwei elektrischen Energiespeichereinheiten (41) vor dem Entladen;
b) Entladen der mindestens zwei elektrischen Energiespeichereinheiten (41) von einem vordefinierten ersten Spannungsniveau oder von einem vordefinierten ersten Ladezustandsniveau auf ein vordefiniertes zweites Spannungsniveau oder auf ein vordefiniertes zweites Ladezustandsniveau.
c) Ermitteln einer Zeitspanne, die das Entladen in Schritt b) benötigt;
d) Bestimmen des Alterungszustandes mindestens einer der mindestens zwei elektrischen Energiespeichereinheiten (41) in Abhängigkeit zumindest der ermittelten Zeitspanne.

2. Verfahren gemäß dem vorhergehenden Anspruch, weiterhin umfassend:
e) Laden oder Entladen der mindestens zwei elektrischen Energiespeichereinheiten (41) auf das vordefinierte erste Spannungsniveau oder das vordefinierte erste Ladezustandsniveau vor dem Schritt b) des Spannungsabgleichs.

3. Verfahren gemäß einem der vorhergehenden Ansprüche, wobei das Entladen in Schritt b) über mindestens einen Widerstand erfolgt, der zu der mindestens einen elektrischen Energiespeichereinheit (41) parallel geschaltet wird.

4. Verfahren gemäß einem der vorhergehenden Ansprüche, weiterhin umfassend
f) Ermitteln einer Temperatur der mindestens einen elektrischen Energiespeichereinheit (41);
wobei das Bestimmen des Alterungszustandes in Schritt d) zusätzlich in Abhängigkeit zumindest der ermittelten Temperatur erfolgt.

5. Verfahren gemäß einem der vorhergehenden Ansprüche, wobei der vollgeladene Zustand der elektrischen Energiespeichereinheit (41) durch das vordefinierte erste Spannungsniveau oder das vordefinierte erste Ladezustandsniveau gekennzeichnet wird.

6. Vorrichtung (42) zur Bestimmung des Alterungszustandes mindestens einer elektrischen Energiespeichereinheit (41), umfassend mindestens ein Mittel, insbesondere eine elektronische Steuereinheit, das eingerichtet ist, die Schritte des Verfahrens nach einem der Ansprüche 1 bis 5 auszuführen.

7. Computerprogramm umfassend Befehle, die bewirken, dass die Vorrichtung (42) nach Anspruch 6 alle Schritte des Verfahrens nach einem der Ansprüche 1 bis 5 ausführt.

8. Maschinenlesbares Speichermedium, auf dem das Computerprogramm nach Anspruch 7 gespeichert ist.

9. Elektrisches Energiespeichersystem (4), umfassend mindestens eine elektrische Energiespeichereinheit (41) und eine Vorrichtung (42) nach Anspruch 6.

## Claims

1. Method for determining a state of health of at least one electrical energy storage unit (41), comprising the steps of:
a) performing voltage balancing between at least two electrical energy storage units (41) prior to discharge;
b) discharging the at least two electrical energy storage units (41) from a predefined first voltage level or from a predefined first state of charge level to a predefined second voltage level or to a predefined second state of charge level;
c) ascertaining a time period required for the discharging in step b);
d) determining the state of health of at least one of the at least two electrical energy storage units (41) depending on at least the time period ascertained.

2. Method according to the preceding claim, furthermore comprising:
e) charging or discharging the at least two electrical energy storage units (41) to the predefined first voltage level or the predefined first state of charge level before step b) of the voltage balancing.

3. Method according to either one of the preceding claims, wherein the discharging in step b) is carried out by means of at least one resistor which is connected in parallel with the at least one electrical energy storage unit (41).

4. Method according to any one of the preceding claims, furthermore comprising f) ascertaining a temperature of at least one electrical energy storage unit (41); wherein the determination of the state of health in step d) is additionally carried
out depending on at least the temperature determined.

5. Method according to any one of the preceding claims, wherein the fully charged state of the electrical energy storage unit (41) is **characterized by** the predefined first voltage level or the predefined first state of charge level.

6. Apparatus (42) for determining the state of health of at least one electrical energy storage unit (41), comprising at least one means, in particular an electronic control unit, which is configured to execute the steps of the method according to any one of Claims 1 to 5.

7. Computer program comprising instructions which cause the apparatus (42) according to Claim 6 to carry out all the steps of the method according to any one of Claims 1 to 5.

8. Machine-readable storage medium on which the computer program according to Claim 7 is stored.

9. Electrical energy storage system (4), comprising at least one electrical energy storage unit (41) and an apparatus (42) according to Claim 6.

## Revendications

1. Procédé de définition d'un état de vieillissement d'au moins une unité d'accumulation d'énergie électrique (41), comprenant les étapes :
a) réalisation d'un équilibrage de tension entre au moins deux unités d'accumulation d'énergie électrique (41) avant le déchargement ;
b) déchargement des au moins deux unités d'accumulation d'énergie électrique (41) d'un premier niveau de tension prédéfini ou d'un premier niveau d'état de charge prédéfini sur un deuxième niveau de tension prédéfini ou sur un deuxième niveau d'état de charge prédéfini ;
c) détermination d'une période de temps nécessaire au déchargement dans l'étape b) ;
d) définition de l'état de vieillissement d'au moins une des au moins deux unités d'accumulation d'énergie électrique (41) en fonction d'au moins la période de temps déterminée.

2. Procédé selon la revendication précédente, comprenant par ailleurs :
e) chargement ou déchargement des au moins deux unités d'accumulation d'énergie électrique (41) sur le premier niveau de tension prédéfini ou sur le premier niveau d'état de charge prédéfini avant l'étape b) de l'équilibrage de tension.

3. Procédé selon l'une des revendications précédentes, le déchargement dans l'étape b) étant effectué par au moins une résistance, qui est branchée en parallèle par rapport à l'au moins une unité d'accumulation d'énergie électrique (41).

4. Procédé selon l'une des revendications précédentes, comprenant par ailleurs :
f) détermination d'une température de l'au moins une unité d'accumulation d'énergie électrique (41) ;
la définition de l'état de vieillissement dans l'étape d) étant effectuée en supplément en fonction au moins de la température déterminée.

5. Procédé selon l'une des revendications précédentes, l'état de pleine charge de l'unité d'accumulation d'énergie électrique (41) étant **caractérisé par** le premier niveau de tension prédéfini ou le premier niveau d'état de charge prédéfini.

6. Dispositif (42) de définition de l'état de vieillissement d'au moins une unité d'accumulation d'énergie électrique (41), comprenant au moins un moyen, en particulier une unité de commande électronique, qui est mis au point pour exécuter les étapes du procédé selon l'une des revendications 1 à 5.

7. Programme informatique, comprenant des instructions qui ont pour effet que le dispositif (42) selon la revendication 6 exécute toutes les étapes du procédé selon l'une des revendications 1 à 5.

8. Support de stockage lisible par machine, sur lequel est stocké le programme informatique selon la revendication 7.

9. Système d'accumulation d'énergie électrique (4), comprenant au moins une unité d'accumulation d'énergie électrique (41) et un dispositif (42) selon la revendication 6.
